Europäisches Patentamt

European Patent Office

Office européen des brevets

(19)

(11) EP 0 569 392 B1

(12) EUROPÄISCHE PATENTSCHRIFT

(45) Veröffentlichungstag und Bekanntmachung des Hinweises auf die Patenterteilung:
01.10.1997 Patentblatt 1997/40

(51) Int Cl.⁶: H03J 3/10

(21) Anmeldenummer: 92902830.6

(22) Anmeldetag: 18.01.1992

(86) Internationale Anmeldenummer:
PCT/EP92/00091

(87) Internationale Veröffentlichungsnummer:
WO 92/13389 (06.08.1992 Gazette 1992/21)

(54) **VERFAHREN UND SCHALTUNG FÜR EINE AUTOMATISCHE, HOCHPRÄZISE FREQUENZ-FEINABSTIMMUNG**

METHOD AND CIRCUIT FOR AUTOMATIC, HIGH-PRECISION FREQUENCY FINE-TUNING

PROCEDE ET CIRCUIT POUR UN REGLAGE FIN DES FREQUENCES, AUTOMATIQUE ET DE HAUTE PRECISION

(84) Benannte Vertragsstaaten:
DE ES FR GB IT PT

(30) Priorität: 29.01.1991 DE 4102562

(43) Veröffentlichungstag der Anmeldung:
18.11.1993 Patentblatt 1993/46

(73) Patentinhaber: DEUTSCHE THOMSON-BRANDT GMBH
78048 Villingen-Schwenningen (DE)

(72) Erfinder:
• KOBLITZ, Rudolf
F-38240 Meylan (FR)
• RIEGER, Martin
D-D 78628 Rottweil (DE)
• ROTH, Sabine
D-78048 Villingen-Schwenningen (DE)

(74) Vertreter: Hartnack, Wolfgang, Dipl.-Ing.
Deutsche Thomson-Brandt GmbH
Licensing & Intellectual Property,
Göttinger Chaussee 76
30453 Hannover (DE)

(56) Entgegenhaltungen:
• DE-A- 2 852 839
• US-A- 4 245 351

Bemerkungen:
Verbunden mit 92200183.9/0501536 (europäische Anmeldenummer/Veröffentlichungsnummer) durch Entscheidung vom 14.06.95.

**Beschreibung**

Die Erfindung betrifft ein Verfahren und eine Schaltung für eine automatische, hochpräzise Frequenz-Feinabstimmung mit Hilfe einer frequenzabgleichbaren Analog-Schaltung in einem integrierten Schaltkreis.

Stand der Technik

Im Bereich der elektronischen Signalverarbeitung ist es häufig erforderlich, Frequenzen oder frequenzabhängige Schaltungen genau abzugleichen, z.B. beim Abstimmen von Tunern oder beim Abgleich von Frequenzgeneratoren.

Entsprechende AFT-Verfahren (automatic fine tune, automatische Feinabstimmung) sind z.B. aus "Television Engineering Handbook", Seite 13.117, K.Blair Benson, McGraw-Hill Book Company, bekannt. Dabei wird die Phasenverschiebung an einem Parallelschwingkreis ausgewertet.

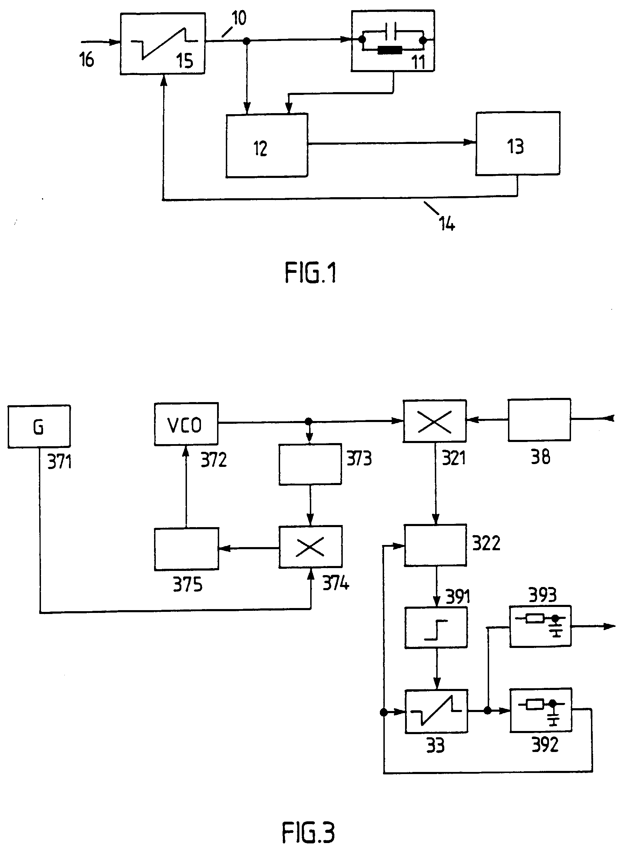

Fig. 1 zeigt ein entsprechendes Blockschaltbild. Ein von einer Abstimmung beeinflußtes Ausgangssignal 10, z.B. ein Fernsehton-Signal, wird einer Schwingkreisschaltung 11 und einem ersten Eingang eines Phasen-Detektors 12 zugeführt. Die Schwingkreisschaltung ist auf eine Soll-Frequenz abgestimmt. Das Ausgangssignal der Schwingkreisschaltung 11 wird einem zweiten Eingang des Phasen-Detektors zugeführt. Das Ausgangssignal des Phasen-Detektors wird in einem Tiefpaß 13 gefiltert und dient als Regelgröße 14 für die Abstimmung des Eingangssignals 10. Eine dafür geeignete Schaltung ist z.B. ein durch eine Regelgröße abstimmbarer FM-Demodulator 15, dem die Regelgröße 14 und ein zu demodulierendes Signal 16 zugeleitet werden. In diesem Anwendungsfall ist mit dem Stand der Technik aber nur eine Abstimmungsgenauigkeit von etwa 150kHz erreichbar. Außerdem sind solche bekannten AFT-Schaltungen nicht vollständig integrierbar. Es werden z.B. zwei Anschlüsse an einem integrierten Schaltkreis für einen externen Schwingkreis benötigt.

Eine weitere bekannte Lösung besteht darin, die abzustimmende Frequenz digital zu zählen und entsprechend nachzuregeln. Der dazu benötigte Schaltungsaufwand und eine dementsprechende Chipfläche in einem integrierten Schaltkreis sind aber hoch. Der Stromverbrauch für eine solche digitale AFT-Schaltung ist vergleichsweise ebenfalls hoch.

US-A-4 245 351 offenbart eine integrierbare, automatische Frequenz-Feinabstimmung, bei der eine frequenzabgleichbare Analogschaltung in zwei nacheinander eingestellten Betriebsarten erst über eine PLL und dann über eine AFT-Regelung feinabgestimmt wird.

Erfindung

Der Erfindung liegt die Aufgabe zugrunde, ein Verfahren zur automatischen, hochpräzisen Frequenz-Feinabstimmung mit geringem Schaltungsaufwand und Stromverbrauch in integrierten Schaltkreisen anzugeben.

Im Prinzip besteht das erfindungsgemäße Verfahren, das durch Anspruch 1 definiert wird, darin, das durch Anspruch 1 definiert wird, daß zum Zweck einer automatischen, hochpräzisen Frequenz-Feinabstimmung, z.B. auf einen bestimmten Fernsehkanal, für eine frequenzabgleichbare Analog-Schaltung in einem integrierten Schaltkreis in Abhängigkeit von einer hochpräzisen Bezugs-frequenz mindestens eine Regelgröße für die frequenzableichbare Analog-Schaltung gebildet und gespeichert wird, deren Wert ebenfalls von einem Referenz-Schaltungsteil in dem integrierten Schaltkreis beeinflußt wird, und daß für die Feinabstimmung nacheinander verschiedene Betriebsarten eingeschaltet werden.

Vorteilhafte Weiterbildungen des erfindungsgemäßen Verfahrens ergeben sich aus den abhängigen Ansprüchen 2 bis 7.

Der Erfindung liegt die weitere Aufgabe zugrunde, eine Schaltung für das erfindungsgemäße Verfahren anzugeben.

Im Prinzip ist die erfindungsgemäße Schaltung, die durch Anspruch 8 definiert wird, versehen mit einer mit einer Regelgröße frequenzabgleichbaren Analog-Schaltung 23, 33, mit einem Einspeisepunkt für eine hochpräzise Bezugs-frequenz $f_{ch}$, mit einem ersten, zweiten und dritten Umschalter, mit einem ersten T1, zweiten T2 und dritten T3 Regelverstärker, mit einem ersten CL und einem zweiten CH Komparator, mit einem Summierer 21 und mit einem internen Kondensator $C_{int}$, wobei zugeführt wird:

- eine Ausgangsspannung $V_1$ der Analog-Schaltung 23 zweiten Eingängen des ersten T1 und zweiten T2 Regelverstärkers und des ersten CL und zweiten CH Komparators;
- eine Referenzspannung $V_{ref}$ einem ersten Eingang 251 des ersten Regelverstärkers T1 in einem Normal-Mode;
- eine kombinierte Spannung aus der Referenzspannung $V_{ref}$ und einer Kompensationsspannung $V_{of}$ einem ersten Eingang 252 des zweiten Regelverstärkers T2 in einem Kalibrier-Mode;
- eine Differenzspannung aus der Referenzspannung $V_{ref}$ und einer Schwellspannung $V_{th}$ einem ersten Eingang 254 des ersten Komparators CL und eine Summenspannung aus der Referenzspannung $V_{ref}$ und der Schwell-

spannung $V_{th}$ einem ersten Eingang 253 des zweiten Komparators CH in einem Meß-Mode;

- ein Ausgangssignal des ersten Regelverstärkers T1 einem ersten Eingang N des dritten Umschalters im Normal-Mode;
- ein Ausgangssignal des zweiten Regelverstärkers T2 einem dritten Eingang C des dritten Umschalters im Kalibrier-Mode;
- ein Ausgangssignal des dritten Umschalters einem Eingang des dritten T3 Regelverstärkers;
- ein Ausgangssignal des dritten T3 Regelverstärkers einem ersten Eingang des Summierers 21;
- ein von der Größe des internen Kondensators $C_{int}$ abgeleitetes und mit einem Faktor k umgeformtes Signal einem zweiten Eingang des Summierers 21;
- ein Ausgangssignal des Summierers 21 einem Steuereingang der Analog-Schaltung 23;
- ein in der Analog-Schaltung 23 zu verarbeitendes Nutzsignal einem ersten Eingang N des ersten Umschalters im Normal-Mode;
- eine Zusatzsignal-Frequenz einem zweiten Eingang C, M des ersten Umschalters im Kalibrier- und im Meß-Mode;
- die hochpräzise Bezugsfrequenz $f_{ch}$ oder eine davon abgeleitete Frequenz einem ersten Eingang C des zweiten Umschalters im Kalibrier-Mode;
- eine vom Ausgangssignal des ersten Umschalters abgeleitete Signalfrequenz einem zweiten Eingang N, M des zweiten Umschalters;
- ein Ausgangssignal des zweiten Umschalters der Analog-Schaltung 23.

Die Ausgangssignale des ersten und des zweiten Komparators können dann z.B. dazu verwendet werden, einen Oszillator in einem Fernsehgeräte-Tuner abzustimmen.

Vorteilhafte Weiterbildungen der erfindungsgemäßen Schaltung ergeben sich aus den Unteransprüchen 9 bis 11.

Das Verfahren ist für integrierte Schaltkreise geeignet und ermöglicht eine automatische Frequenz-Feinabstimmung unter Verwendung von frequenzabgleichbaren Analog-Schaltungen, beispielsweise FM-Demodulatoren oder Frequenz-Generatoren. Die erfindungsgemäße AFT-Schaltung enthält eine automatisch arbeitende Regelschleife mit einer darin gebildeten Regelgröße. Diese Regelgröße wird zusätzlich von einem Referenz-Bauelement, z.B. einer Referenz-Kapazität, auf dem Substrat des integrierten Schaltkreises beeinflußt, wobei in einem jeweiligen Wert dieses Referenz-Bauelementes Fertigungstoleranzen bei der Herstellung des integrierten Schaltkreises ihren Ausdruck finden. Als Referenz wird der AFT-Schaltung in einem Kalibrier-Mode eine Bezugs-Frequenz mit der erforderlichen Genauigkeit zugeführt. Es sind dabei drei Betriebsarten vorgesehen, um die AFT-Funktion durchführen zu können:

a) Normal-Mode,
b) Kalibrier-Mode,
c) Meß-Mode.

Im Kalibrier-Mode wird zunächst die Analog-Schaltung frequenzabgeglichen. Dieser Abgleich bleibt dann bis zu einem erneuten Einschalten des Kalibrier-Modes erhalten. Im Meß-Mode wird danach ein aktueller Wert einer feinabzustimmenden Frequenz mit Hilfe der zuvor abgeglichenen Analog-Schaltung ermittelt. Jenachdem, ob dieser ermittelte Wert kleiner, gleich oder größer als ein Sollwert für die feinabzustimmende Frequenz ist, findet dann eine entsprechende Feinabstimmung statt. Anschließend wird der Normal-Mode eingeschaltet, in dem die Analog-Schaltung für ihre eigentliche Aufgabe genutzt wird.

Vorteilhaft wird der Abgleich und die Feinabstimmung stromgesteuert unter Verwendung eines Speicherkondensators und von Transkonduktanzverstärkern.

Zeichnungen

Anhand der Zeichnungen werden Ausführungsbeispiele der Erfindung beschrieben. Die Zeichnungen zeigen in:

Fig. 1     eine bekannte AFT-Schaltung;
Fig. 2     eine erfindungsgemäße AFT-Schaltung;
Fig. 3     die Anwendung der erfindungsgemäßen AFT-Schaltung in einer erweiterten integrierten Schaltung für Fernsehgeräte.

Ausführungsbeispiele

Im folgenden werden zunächst drei Betriebsarten der AFT-Schaltung für den Abgleich eines FM-Demodulators und für die Generierung von Signalen zur Feinabstimmung beschrieben. Wenn z.B. ein Fernsehgerät eingeschaltet oder der Empfangskanal in diesem Fernsehgerät gewechselt wird, wird zunächst kurzzeitig der Kalibrier-Mode gewählt (diese Wahl und die Wahl der anderen Betriebsarten geschieht vorteilhaft automatisch). Dabei wird der FM-Demodulator mit Hilfe einer präzisen Referenzfrequenz, z.B. der Farbträgerfrequenz, durch eine Regelgröße feinabgeglichen und ein Maß für diese Regelgröße gespeichert.

Anschließend wird kurzzeitig der Meß-Mode gewählt. Anhand der Ausgangsspannung des zuvor abgeglichenen FM-Demodulators detektieren zwei Komparatoren, ob die ZF-Frequenz und damit die Frequenz des Tuner-Oszillators beibehalten, vermindert oder vergrößert werden muß.

Nachdem der Tuner-Oszillator abgeglichen worden ist, wird der Normal-Mode eingeschaltet.

1. Normal-Mode

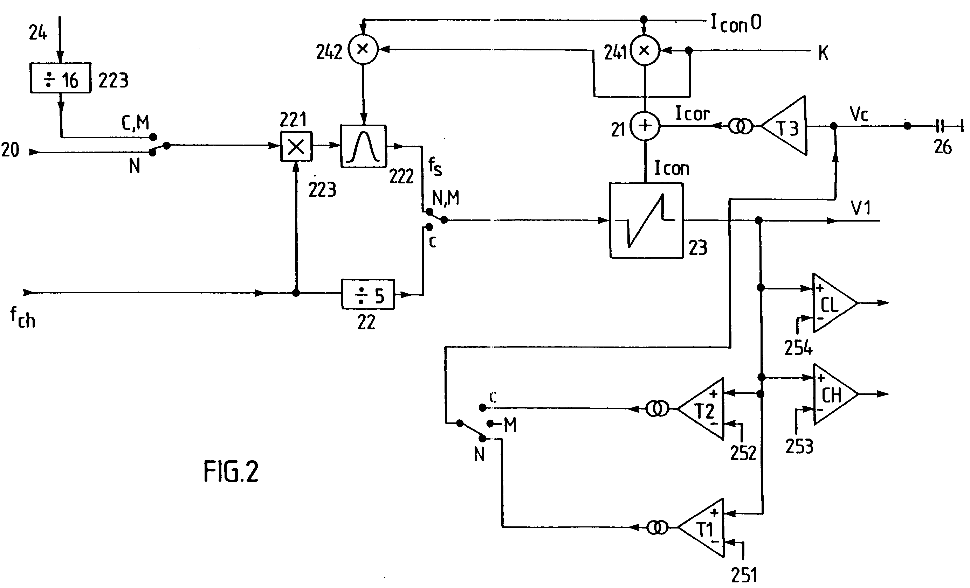

In Fig. 2 entspricht die Schalterstellung "N" dieser Betriebsart. Die Gesamtschaltung arbeitet als FM-Demodulator mit automatischem Abgleich der Mittenfrequenz. Als Signalquelle dient beispielsweise das ZF-Ausgangs-Tonsignal 20 eines 4.5MHz-Bandpaßfilters. Dieses Ausgangssignal wird in einem Mischer 221, dem ebenfalls die Frequenz $f_{ch}$ = 3.579545-MHz eines Farbträger-Oszillators zugeführt wird, auf 920kHz umgesetzt, in einem Filter 222 mit der Güte Q = 3 bandpaßgefiltert und bildet dann das Eingangssignal $f_S$, welches in einem FM-Demodulator 23 demoduliert wird.

Der FM-Demodulator 23 enthält einen internen, stromgesteuerten Oszillator (nicht dargestellt) mit einer nicht synchronisierten Frequenz

$$f_1 = k_d * I_{con} / C_{int'} \tag{1}$$

wobei $k_d$ eine erste Konstante, $I_{con}$ der Steuerstrom für den FM-Demodulator 23 und

$$C_{int} = C_{nom} \pm \Delta C \tag{2}$$

ein auf der Schaltung integrierter, interner Kondensator (nicht dargestellt) mit einem Nennwert von $C_{nom}$ und einer absoluten Fertigungs-Toleranz von $\pm \Delta C$ ist.

Die nicht synchronisierte Frequenz des Oszillators und damit die Abstimmung des FM-Demodulators kann auf die Frequenz des Eingangssignals $f_s$ synchronisiert werden, falls

$$\left| f_s - f_1 \right| \leq \Delta f_1, \tag{3}$$

mit $\Delta f_1$ = Synchronisier-Bereich.

Wenn das Eingangssignal $f_s$ frequenzmoduliert ist, gilt

$$f_s = f_c + \Delta f_s(t), \tag{4}$$

wobei $f_c$ die Mittenfrequenz und $\Delta f_s$ der Hub ist. Für die Frequenz $f'_1$ des synchronisierten Oszillators gilt $f'_1 = f_s$, solange $\Delta f_s \leq \Delta f_1$. Dann stellt die tiefpaßgefilterte Ausgangsspannung $V_1$ das demodulierte Tonsignal dar,

$$V_1 = -k_f * (f_1 - f_c) + V_{ref'} \tag{5}$$

wobei $k_f$ die Steilheit der Demodulatorkennlinie und $V_{ref}$ eine Referenzspannung ist.

In der AFT-Schaltung in Fig. 2 soll zum besseren Verständnis zunächst kein ZF-Ausgangs-Tonsignal 20 anliegen. Ein erster Transkonduktanz-Verstärker $T_1$, ein Speicherkondensator $C_{stor}$, ein dritter Transkonduktanz-Verstärker $T_3$ und der FM-Demodulator 23 bilden eine Abgleich-Schleife. Dem Eingang 251 des ersten Transkonduktanzverstärkers wird die Referenzspannung $V_{ref}$ zugeführt. Wenn zwischen der Mittenfrequenz $f_c$ und der Frequenz $f_1$ eine Frequenz-differenz im Bereich

$$O \leq \left| f_1 - f_d \right| \leq \Delta f_1 \tag{6}$$

auftritt, korrigiert die automatische Abgleich-Schleife die Frequenz $f_1$ zu $f_1 = f_c$ in der folgenden Weise: Wenn die

Ausgangs-Spannung $V_1$ sich entsprechend Gleichung (5) ändert, lädt der erste Transkonduktanz-Verstärker $T_1$ (dieser hat eine Transkonduktanz $k_1$) mit einem maximalen Ausgangsstrom von z.B. ±0.5µA einen externen Speicherkondensator 26 ($C_{stor}$) auf eine Speicherspannung

$$V_C = (V_1 - V_{ref})*k_1/(p*C_{stor}), \qquad (7)$$

wobei p die komplexe Frequenz ist. Entsprechend der Speicherspannung $V_c$ erzeugt der dritte Transkonduktanzverstärker $T_3$ (dieser hat eine Transkonduktanz $k_3$) einen Korrekturstrom

$$I_{cor} = k_3 * V_{c'} \qquad (8)$$

der in einem Summierer 21 zu einem, z.B. Fertigungstoleranzen berücksichtigenden, Steuerstrom $I_{conO}$ addiert wird und dann den Demodulator-Steuerstrom

$$I_{con} = k * I_{conO} + I_{cor} \qquad (9)$$

bildet. Der Steuerstrom $I_{conO}$ kann auch zum Abgleich des Filters 222 dienen. Ein erster 241 und ein zweiter 242 Multiplizierer multiplizieren dabei den Steuerstrom $I_{conO}$ im Normal-Mode mit einem Faktor k = 1.

Aus den Gleichungen (1), (2), (5) und (7) bis (9) enthält man durch entsprechende Umformung die korrigierte Frequenz

$$f_{1c} = k_d/(C_{nom} \pm \Delta C) * [I_{conO} - k_3 * k_1 * k_f * (f_1 - f_c)/(p*C_{stor})]. \qquad (10)$$

Typische Werte sind $k_d = 1$, $f_s = 920kHz$, $C_{int} = C_{nom} = 10pF$, $I_{con} = I_{conO}$, $f_1 = f_s$, $V_1 = V_{ref}$, $C_{stor} = 1nF$.

Die Grenzfrequenz in der Abgleich-Schleife liegt bei 20Hz, um zu vermeiden, daß Tonsignal-Anteile im Korrekturstrom $I_{cor}$ Verzerrungen erzeugen.

Der Korrekturstrom $I_{cor}$ kann vorteilhaft auch ausgenutzt werden, um das Filter 222 abzustimmen, z.B. durch Verwendung eines zweiten Summierers oder durch direkte Zuführung des Demodulator-Steuerstromes $I_{con}$ zu diesem Filter (nicht dargestellt).

Das Signal/Rausch-Verhältnis des FM-Demodulators 23 ist etwa umgekehrt proportional zum Synchronisier-Bereich $\Delta f_1$. Darum sollte $\Delta f_1$ so klein wie möglich gemacht werden.

Falls die automatische Abgleich-Schleife nicht benutzt wird und $I_{corO}$ anstelle von Korrekturstrom $I_{cor}$ ein konstanter Strom unabhängig vom Absolutwert des internen Kondensators $C_{int}$ ist, kann man aus den Gleichungen (1) und (2) erkennen, daß die Frequenz $f_1$ von der absoluten Toleranz $\Delta C$ abhängt. Diese Toleranz hat eine Größe von etwa ±15%. Unter diesen Bedingungen und um noch eine gute Synchronisierung sicherzustellen, sollte $\Delta f_1$ einen minimalen Wert von

$$\Delta f_1 = \Delta f_s + (\Delta C/C_{nom}) * f_c \qquad (11)$$

nicht unterschreiten.

Ein vorteilhafter Wert für $\Delta f_1$ ergibt sich mit den entsprechenden Zahlenwerten

$$\Delta f_1 = 70kHz + 0.15 * 920kHz = 208kHz.$$

Nun sei der Demodulator-Steuerstrom $I_{con}$ proportional zum internen Kondensator $C_{int}$. Dadurch verändert sich der zweite Term auf der rechten Seite von Gleichung (11) und der Synchronisier-Bereich $\Delta f_1$ wird zu

$$\Delta f_1 \geq \Delta f_s = df_1 * f_c \qquad (11a)$$

wobei $df_1$ einen Frequenz-Offset darstellt, der seine Ursache in dem unterschiedlichen Verhalten zwischen dem FM-Demodulator 23 und den den Demodulator-Steuerstrom $I_{con}$ erzeugenden Bauelementen hat, betreffend thermische Drift und parasitäre Effekte. Der maximale Wert von $df_1$ ist etwa 5%. Die obengenammten Zahlenwerte ändern sich dann in $\Delta f_1 = 70kHz + 0.05*920kHz = 116kHz$.

Wenn nun zusätzlich die automatische Abgleichschleife in Funktion ist, verliert $df_1$ seine Bedeutung und wird in Gleichung (11a) zu Null, und der Zahlenwert für $\Delta f_1$ ändert sich in $\Delta f_1 = 70kHz$.

2. Kalibrier-Mode

Die AFT-Schaltung kann kalibriert werden. In Fig. 2 entspricht die Schalterstellung "C" dieser Betriebsart. Dazu wird eine genaue, bekannte Frequenz verwendet. Beispielsweise wird die quarzstabile Frequenz $f_{ch} = 3.579545MHz$ eines Farboszillators in einem ersten Teiler 22 auf ein fünftel herabgesetzt. Es ergibt sich so die Kalibrier-Frequenz $f_{cal} = 715.909kHz$. Der Demodulator-Steuerstrom $I_{con0}$ wird beispielsweise im ersten 241 und zweiten 242 Multiplizierer um den Faktor k = 0.78 herabgesetzt. Damit wird die kalibrierte Frequenz zu

$$f_{1cal} = 0.78*f_1 = 717kHz. \tag{12}$$

Aufgrund des Frequenz-Offsets

$$\Delta F = f_{mea} - f_{cal} \tag{13}$$

zwischen der Kalibrier-Frequenz $f_{cal}$ (715.909kHz) und einer AFT-Meßfrequenz $f_{mea}$, wird einem zweiten Transkonduktanzverstärker T2 an seinem Eingang 252 eine Kompensationsspannung $V_{ref} - V_{of}$ zugeführt. $V_{of}$ ergibt sich entsprechend Gleichung (5) zu

$$V_{of} = \Delta F*k_f. \tag{14}$$

Der zweite Transkonduktanzverstärker T2 liefert einen maximalen Ausgangsstrom von z.B. $\pm 300\mu A$ bei einer Transkonduktanz $k_2$ und lädt den Speicherkondensator 26 ($C_{stor}$) so, daß für die korrigierte, kalibrierte Frequenz gilt:

$$f'_{1cal} = f_{1cal} + V_{of}/k_f \tag{15}$$

Ähnlich Gleichung (10) gilt dann

$$f'_{1cal} = k_d/(C_{nom} \pm \Delta C)*\{I_{con0} - k_3*k_2*[k_f*(f_{1cal} - f_{cal}) - V_{of}]/ (p*C_{stor})\} \tag{16}$$

Der theoretische Frequenz-Fehlabgleich aufgrund des unterschiedlichen Verhaltens zwischen FM-Demoduiacor 23 und den den Demodulator-Steuerstrom Icon erzeugenden Bauelementen ergibt sich zu

$$f_{1cal} + \Delta F - f_{cal} = df_{1cal}*f_{cal} \tag{17}$$

$= 0.05*717kHz = 35.9\ kHz$ und wird vorteilhaft wie im Normal-Mode durch die automatische Abstimmung eliminiert. Einem Zwischenfrequenz-Eingang 24 wird eine Zwischenfrequenz $f_{IF} = 45.75MHz$ zugeführt, die in einem nachfolgenden zweiten Teiler 223 z.B. um den Faktor n = 16 herabgesetzt wird. Diese herabgesetzte Frequenz wird im Mischer 221 mit der Farboszillator-Frequenz $f_{ch}$ gemischt, wodurch am Eingang des FM-Demodulators 23 eine Meßfrequenz

$$f_{mea} = f_{IF}/16 - f_{ch} \tag{18}$$

anliegt. Wenn beispielsweise $f_{mea} = 45.75MHz/16 - 3.579545MHz = 720.17kHz$ und $k_f = 20mV/kHz$, ergibt sich $\Delta F = 4.261\ kHz$ und $V_{of} = 85\ mV$.

Die Grenzfrequenz der Abgleichschleife ist um den Faktor $k_2/k_1 = 300\mu A/0.5\mu A = 600$ mal höher als im Normal-Mode und ergibt sich zu etwa 10kHz. Dies erlaubt eine vorteilhaft kurze Kalibrationszeit von $t_{cal} < 10/f_{1cal} \simeq$ 1ms.

3. Meß-Mode

Bevor die AFT-Schaltung im Meß-Mode arbeiten kann, muß sie wie unter 2.) beschrieben kalibriert werden.

In Fig. 2 entspricht die Schalterstellung "M" der Betriebsart "Meß-Mode". Die Signalquelle im Meß-Mode ist entweder ein Zwischenfrequenz-VCO (voltage controlled oscillator) oder ein verstärktes und begrenztes Zwischenfrequenz-Signal am Zwischenfrequenz-Eingang 24. Die Frequenz $f_{IF}$ dieses Zwischenfrequenz-Signals wird im zweiten Teiler 223 um den Teiler-Faktor n, z.B. n = 16, herabgesetzt und im Mischer 221 mit der Farboszillator-Frequenz $f_{ch}$ gemischt, wodurch am Eingang des FM-Demodulators 23 wie im Kalibrier-Mode eine Meßfrequenz $f_{mea} = f_{IF}/16\text{-}f_{ch}$ anliegt.

Für $f_{IF}$ = 45.75MHz, n = 16 und $f_{ch}$ = 3.579545MHz ist wieder $f_{mea}$ = 720.17kHz.

Der Steuerstrom $I_{conO}$ und damit die frequenz $f_{1mea}$ des internen Oszillators des FM-Demodulators 23 wird wie im Kalibrier-Mode mit k = 0.78 multipliziert.

Weil die automatische Abgleich-Schleife im Meß-Mode offen ist, bleibt die Speicherspannung $V_c$ konstant und $f_{1mea}$ ist gleich $f'_{1cal}$, z.B. wie in Gleichung (16). Die im Abschnitt 2.) genannte Kompensationsspannung $V_{of}$ wurde so gewählt, daß im Meß-Mode die nominale Meßfrequenz $f_{meanom}$ aus dem von der Zwischenfrequenz $f_{IF}$ abgeleiteten Signal gleich $f_{1cal}$ ist. Die Ausgangsspannung $V_1$ wird zusätzlich einem ersten Komparator CL und einem zweiten Komparator CH zugeführt. Der erste Komparator erhält zusätzlich an seinem Eingang 254 die Spannung $V_{ref}\text{-}V_{th}$ und der zweite Komparator an seinem Eingang 253 die Spannung $V_{ref}\text{+}V_{th}$, wobei $V_{th}$ eine Schwellspannung ist. Die beiden Komparatoren CL und CH mit der Schwellspannung $V_{th}$ detektieren, ob $f_{mea}$ den korrekten Wert hat ($f_{mea} \simeq f_{meanom}$) oder zu hoch oder zu niedrig ist.

Wenn wie im Kalibrier-Mode die Steilheit der DemodulatorKennlinie $k_f$ = 20mV/kHz ist, wird als Schwellspannung vorteilhaft gewählt $V_{th} = k_f*1\text{kHz}$ = 20mV.

Dies bewirkt einen Pegelsprung der Ausgangssignale der Komparatoren, falls $|f_{meanom}\text{-}f_{mea}| \geq$ 1kHz.

Die daraus resultierende Fehlabstimmung der Zwischenfrequenz ist $\Delta f_{IF} = n*V_{th}/k_f$, was im obengenannten Beispiel $\Delta f_{IF}$ = 16kHz ergibt.

Wenn der FM-Demodulator 23 für einen Synchronisier-Bereich mit dem Betrag $\Delta f_1$ ausgelegt wird, kann die AFT-Schaltung eine ZF-Fehlabstimmung bis zu $n* \Delta f_1$ ausregeln.

Beispielsweise ist für n = 16 $\Delta f_1$ = 100kHz ein vorteilhafter Wert.

Vorteilhaft hat in Fig. 2 die Referenzspannung $V_{ref}$ den halben Wert der Betriebsspannung $V_{cc}$ der integrierten Schaltung.

Statt der dem Mischer 221 und dem ersten Teiler 22 zugeführten Frequenz $f_{ch}$ können auch Frequenzen von einer anderen quarzstabilen Quelle verwendet werden, die dem Mischer zugeführt werden und das Ausgangssignal des ersten Teilers ersetzen.

Für andere Eingangsfrequenzen an den Eingängen 20 und 24 ergeben sich entsprechend geänderte Frequenzen am Ausgang des Filters 222 und des ersten Teilers 22, ein entsprechend geänderter Wert für den Faktor k und ein geänderter Teilerfaktor des ersten Teilers 22. Beispielsweise für eine Fernsehnorm mit CCIR-Standard B/G ergeben sich folgende Werte:

Frequenz am Eingang 223 des Mischers 221: 5.875 MHz
$f_{IF}$ = 38.9MHz
$f_{meanom}$ = 38.9MHz/16-2.9375MHz = 506kHz
$f_{cal}$ = 500kHz
$\Delta F$ = 6kHz
$V_{of} = 6\text{kHz}*K_f$ = 120mV
k im Normal-Mode : 1.00
k sonst : 1.01

In Fig. 3 wird ein Ausschnitt aus einem integrierten Schaltkreis wiedergegeben, in dem eine Tondemodulation mit Hilfe der erfindungsgemäßen AFT-Schaltung dargestellt ist (nur Normal-Mode).

Ein Konverter 38 erhält an seinem Eingang ein ZF-Signal und führt das gefilterte Ausgangssignal, z.B. ein 4.5/5.5/6.OMHz- oder 6.5MHz-Ton-ZF-Signal, einem ersten Eingang eines ersten Mischers 321 zu. Dieser Mischer kann dem Mischer 221 in Fig. 2 entsprechen. An seinem zweiten Eingang erhält der erste Mischer 321 das Ausgangssignal einer VCO-Schaltung 372, die eine geeignete Mischfrequenz bereitstellt. Dieses Ausgangssignal wird über einen Frequenzteiler 373 zu einem ersten Eingang eines zweiten Mischers 374 weitergeleitet, der an seinem zweiten Eingang ein Signal aus einem Referenzoszillator 371 erhält. Das Ausgangssignal des zweiten Mischers 374 wird über ein Schleifenfilter 375 der VCO-Schaltung 372 zugeführt, womit eine Regelschleife geschlossen ist.

Das Ausgangssignal des ersten Mischers 321 gelangt zu einem Filter 322, dessen Funktion dem des Filters 222 in Fig. 2 entspricht. Das gefilterte Signal wird dann über einen Begrenzer 391 einem FM-Demodulator 33 zugeführt. Dieser FM-Demodulator entspricht dem FM-Demodulator 23 in Fig. 2. Die Ausgangssignale des FM-Demodulators 33 werden anschließend in einem ersten Tiefpaßfilter 393 und in einem zweiten Tiefpaßfilter 392 bandbegrenzt. Am Ausgang des ersten Tiefpaßfilters ist ein Audiosignal abgreifbar und am Ausgang des zweiten Tiefpaßfilters eine Regelspannung, die zur Feinabstimmung dem FM-Demodulator 33 und dem Filter 322 zugeführt wird. Die Grenzfrequenz im ersten Tiefpaßfilter liegt z.B. bei 100kHz und im zweiten Tiefpaßfilter z.B. bei 20Hz. Ein zum zweiten Tiefpaßfilter 392 gehörender Kondensator kann auch extern an den integrierten Schaltkreis anschließbar sein.

Im Fall von Stereo- oder Zweiton-Audiosignalen, z.B. beim Zweitonträger-Verfahren, sind das Filter 322, der Begrenzer 391, der FM-Demodulator 33, das erste Tiefpaßfilter 393 und das zweite Tiefpaßfilter 392 entsprechend doppelt vorhanden.

## Patentansprüche

1. Verfahren für eine automatische Frequenz-Feinabstimmung, bei dem innerhalb eines integrierten Schaltkreises verschiedene Betriebsarten einschaltbar sind und bei dem in Abhängigkeit von einer entsprechend genauen Bezugsfrequenz ($f_{ch}$) mindestens eine Regelgröße ($I_{con}$) für den Abgleich gebildet und in dem integrierten Schaltkreis eine frequenzabgleichbare Analog-Schaltung (23, 33) mindestens mit Hilfe dieser Regelgröße feinabgestimmt wird, **gekennzeichnet durch**:

   - der Wert der Regelgröße ($I_{con}$) wird von einem Referenz-Schaltungsteil ($C_{int}$) in dem integrierten Schaltkreis beeinflußt;
   - es sind mindestens die Betriebsarten Kalibrier-Mode (C), Meß-Mode (M) und Normal-Mode (N) vorgesehen;
   - im Kalibrier-Mode wird die Bezugsfrequenz ($f_{ch}$) - insbesondere eine Farbträger-Frequenz - oder eine von dieser Bezugsfrequenz abgeleitete Frequenz ($f_{cal}$) zum Abgleich der Analog-Schaltung verwendet und es wird mindestens ein die Regelgröße ($I_{con}$) beeinflussender Wert ($V_c$) gespeichert ($C_{stor}$);
   - nach einem durchgeführten Abgleich im Kalibrier-Mode wird im Meß-Mode unter Verwendung des die Regelgröße ($I_{con}$) beeinflussenden, gespeicherten Werts ($V_c$) ein Fein-Abgleich für ein in der Analog-Schaltung (23, 33) zu verarbeitendes Signal (20, 24) - insbesondere ein ZF-Signal - durchgeführt;
   - im Normal-Mode wird die Analog-Schaltung während der Verarbeitung des zu verarbeitenden Signals (20, 24) durch die Regelgröße ($I_{con}$) fortlaufend feinabgeglichen.

2. Verfahren nach Anspruch 1, wobei der Referenz-Schaltungsteil ($C_{int}$) ein Abbild darstellt für die durch Fertigungstoleranzen sich ändernden relevanten Parameter für den Abgleich der Analog-Schaltung (23, 33).

3. Verfahren nach Anspruch 1 oder 2, wobei vor einem erstmaligen Abgleich im Normal-Mode (N) oder bei der Wahl einer anderen Frequenz für das in der Analog-Schaltung (23, 33) zu verarbeitende Signal (20, 24) mindestens einmal nacheinander Kalibrier-Mode (C), Meß-Mode (M) und Normal-Mode (N) eingeschaltet werden.

4. Verfahren nach einem oder mehreren der Ansprüche 1 bis 3, wobei die Regelgröße ($I_{con}$) zusammengesetzt ist aus einer von dem die Regelgröße beeinflussenden Wert ($V_c$) direkt abgeleiteten Korrektur-Regelgröße ($I_{cor}$) und aus einer zusätzlichen, die Fertigungstoleranzen berücksichtigenden Steuergröße ($I_{con0}$), wobei diese Regel- bzw. Steuergrößen insbesondere Steuerströme sind und der Anteil der zusätzlichen Steuergröße ($I_{con0}$) an der zusammengesetzten Regelgröße ($I_{con}$) im Kalibrier- und im Meß-Mode entsprechend den verwendeten Frequenzen angepaßt werden kann.

5. Verfahren nach einem oder mehreren der Ansprüche 1 bis 4, wobei der die Regelgröße ($I_{con}$) bzw. Korrektur-Regelgröße ($I_{cor}$) beeinflussende Wert ($V_c$) mit Hilfe der Differenz zwischen einer Ausgangs-Gleichspannungskomponente der Analog-Schaltung (23, 33) und einer jeweils festgelegten Referenzspannung ($V_{ref}$-$V_{of}$; $V_{ref}$) gebildet ist.

6. Verfahren nach einem oder mehreren der Ansprüche 1 bis 5, wobei das Referenz-Schaltungsteil ein Kondensator ($C_{int}$) ist.

7. Verfahren nach einem oder mehreren der Ansprüche 1 bis 6, wobei die frequenzabgleichbare Analog-Schaltung das Referenz-Schaltungsteil enthält und ein FM-Demodulator (23, 33) mit einem internen, stromgesteuerten Oszillator oder ein stromgesteuerter Frequenzgenerator ist.

8. Schaltung für ein Verfahren nach einem oder mehreren der Ansprüche 1 bis 7 versehen mit einer mit einer Regelgröße ($I_{con}$) frequenzabgleichbaren Analog-Schaltung (23, 33), mit einem Einspeisepunkt für eine hochpräzise Bezugsfrequenz ($f_{ch}$), mit einem ersten, zweiten und dritten Umschalter, mit einem ersten (T1), zweiten (T2) und dritten (T3) Regelverstärker, mit einem ersten (CL) und einem zweiten (CH) Komparator, mit einem Summierer (21) und mit einem internen Kondensator ($C_{int}$), wobei zugeführt wird:

- eine Ausgangsspannung (V1) der Analog-Schaltung (23) zweiten Eingängen des ersten (T1) und zweiten (T2) Regelverstärkers und des ersten (CL) und zweiten (CH) Komparators;
- eine Referenzspannung ($V_{ref}$) einem ersten Eingang (251) des ersten Regelverstärkers (T1) in einem Normal-Mode;
- eine kombinierte Spannung aus der Referenzspannung ($V_{ref}$) und einer Kompensationsspannung ($V_{of}$) einem ersten Eingang (252) des zweiten Regelverstärkers (T2) in einem Kalibrier-Mode;
- eine Differenzspannung aus der Referenzspannung ($V_{ref}$) und einer Schwellspannung ($V_{th}$) einem ersten Eingang (254) des ersten Komparators (CL) und eine Summenspannung aus der Referenzspannung ($V_{ref}$) und der Schwellspannung ($V_{th}$) einem ersten Eingang (253) des zweiten Komparators (CH) in einem Meß-Mode;
- ein Ausgangssignal des ersten Regelverstärkers (T1) einem ersten Eingang (N) des dritten Umschalters im Normal-Mode;
- ein Ausgangssignal des zweiten Regelverstärkers (T2) einem dritten Eingang (C) des dritten Umschalters im Kalibrier-Mode;
- ein Ausgangssignal des dritten Umschalters einem Eingang des dritten (T3) Regelverstärkers;
- ein Ausgangssignal des dritten (T3) Regelverstärkers einem ersten Eingang des Summierers (21) ;
- ein von der Größe des internen Kondensators ($C_{int}$) abgeleitetes und mit einem Faktor (k) umgeformtes Signal einem zweiten Eingang des Summierers (21);
- ein Ausgangssignal des Summierers (21) einem Steuereingang der Analog-Schaltung (23);
- ein in der Analog-Schaltung (23) zu verarbeitendes Nutzsignal einem ersten Eingang (N) des ersten Umschalters im Normal-Mode;
- eine Zusatzsignal-Frequenz einem zweiten Eingang (C, M) des ersten Umschalters im Kalibrier- und im Meß-Mode;
- die Bezugsfrequenz ($f_{ch}$) oder eine davon abgeleitete Frequenz ($f_{cal}$) einem ersten Eingang (C) des zweiten Umschalters im Kalibrier-Mode;
- eine vom Ausgangssignal des ersten Umschalters abgeleitete Signalfrequenz ($f_S$) einem zweiten Eingang (N, M) des zweiten Umschalters;
- ein Ausgangssignal des zweiten Umschalters der Analog-Schaltung (23) .

9. Schaltung nach Anspruch 8, wobei der erste, zweite und dritte Regelverstärker Transkonduktanzverstärker und die Ausgangssignale dieser Transkonduktanzverstärker und die Signale am ersten und zweiten Eingang des Summierers (21) und das Ausgangssignal des Summierers Ströme sind.

10. Schaltung nach Anspruch 8 oder 9, wobei die kombinierte Spannung eine Differenzspannung ist.

11. Schaltung nach einem oder mehreren der Ansprüche 8 bis 10, wobei das mit einem Faktor (k) umgeformte Signal ein in einem Multiplizierer (241) mit dem Faktor (k) multipliziertes Signal ist.

## Claims

1. Method for fine tuning a frequency automatically, wherein differing operating modes can be selected for use within an integrated circuit and wherein at least one regulating variable ($I_{con}$) for the adjusting process is formed in dependence on an appropriately accurate reference frequency ($f_{ch}$), and a frequency adjustable analog circuit (23, 33) in the integrated circuit is fine tuned with at least the help of this regulating variable, characterised by:

- the value of the regulating variable (Icon) is affected by a reference circuit portion ($C_{int}$) in the integrated circuit;

- at least the operating modes, calibration mode (C), test mode (M) and normal mode (N) are provided;

- in the calibration mode, the reference frequency ($f_{ch}$) - in particular, a colour carrier frequency - or a frequency ($f_{cal}$) derived from this reference frequency is used for adjusting the analog circuit and at least one value ($V_c$) that affects the regulating variable ($I_{con}$) is stored ($C_{stor}$);

- in the test mode following an adjusting process that has been carried out in the calibration mode, a fine tuning process for a signal (20, 24) - in particular, an IF signal - that is to be processed in the analog circuit (23, 33) is carried out using the stored value ($V_c$) that affects the regulating variable ($I_{con}$) ;

- in the normal mode, the analog circuit is continuously finely adjusted by the regulating variable ($I_{con}$) during the processing of the signal (20, 24) that is to be processed.

2. Method in accordance with Claim 1, wherein the reference circuit portion ($C_{int}$) is representative of those parameters which are relevant for the adjustment of the analog circuit (23, 33) and of those which are subject to variation due to manufacturing tolerances.

3. Method in accordance with Claim 1 or 2, wherein the calibration mode (C), the test mode (M) and the normal mode (N) are successively selected at least once prior to a first occurrence of an adjusting process in the normal mode (N) or during the selection of another frequency for the signal (20, 24) that is to be processed in the analog circuit (23, 33).

4. Method in accordance with one or more of the Claims 1 to 3, wherein the regulating variable ($I_{con}$) is composed of a correcting regulating variable ($I_{cor}$) that is derived directly from the value ($V_c$) that affects the regulating variable and of an additional control variable ($I_{con0}$) that takes manufacturing tolerances into account, whereby these regulating and control variables are, in particular, control currents and the component of the additional control variable ($I_{con0}$) can be adapted to the thus composed regulating variable ($I_{con}$) in the calibration and in the test mode in correspondence with the frequencies being used.

5. Method in accordance with one or more of the Claims 1 to 4, wherein the value ($V_c$) that affects the regulating variable ($I_{con}$) or the correcting regulating variable ($I_{cor}$) is formed with the aid of the difference between an output dc voltage component of the analog circuit (23, 33) and a reference voltage ($V_{ref}$ - $V_{of}$; $V_{ref}$) that is defined on each occasion.

6. Method in accordance with one or more of the Claims 1 to 5, wherein the reference circuit portion is a capacitor ($C_{int}$) .

7. Method in accordance with one or more of the Claims 1 to 6, wherein the frequency adjustable analog circuit includes the reference circuit portion and is an FM demodulator (23, 33) having an internal current controlled oscillator or a current controlled frequency generator.

8. Circuit for a method in accordance with one or more of the Claims 1 to 7, provided with an analog circuit (23, 33) that is adjustable in frequency by means of a regulating variable ($I_{con}$), with a feed point for a highly accurate reference frequency ($f_{ch}$), with a first, second and third switch, with a first (T1), second (T2) and third (T3) servo amplifier, with a first (CL) and a second (CH) comparator, with an adder (21) and with an internal capacitor ($C_{int}$), wherein the following are supplied:

- an output voltage ($V_1$) from the analog circuit (23), to the second inputs of the first (T1) and second (T2) servo amplifiers and the second inputs of the first (CL) and second (CH) comparators;

- a reference voltage ($V_{ref}$), to a first input (251) of the first servo amplifier (T1) in a normal mode;

- a combined voltage formed by the reference voltage ($V_{ref}$) and a compensating voltage ($V_{of}$), to a first input (252) of the second servo amplifier (T2) in a calibration mode;

- a voltage that is the difference between the reference voltage ($V_{ref}$) and a threshold voltage ($V_{th}$), to a first input (254) of the first comparator (CL), and a voltage that is the sum of the reference voltage ($V_{ref}$) and the threshold voltage ($V_{th}$), to a first input (253) of the second comparator (CH) in a test mode;

- an output signal from the first servo amplifier (T1), to a first input (N) of the third switch in the normal mode;

- an output signal from the second servo amplifier (T2), to a third input (C) of the third switch in the calibration mode;

- an output signal of the third switch, to an input of the third servo amplifier (T3);

- an output signal from the third servo amplifier (T3), to a first input of the adder (21);

- a signal derived from the magnitude of the internal capacitor ($C_{int}$) and converted by a factor (k), to a second input of the adder (21);

- an output signal from the adder (21), to a control input of the analog circuit (23) ;

- a wanted signal that is to be processed in the analog circuit (23), to a first input (N) of the first switch in the normal mode;

- an auxiliary signal frequency, to a second input (C, M) of the first switch in the calibration and in the test mode;

- the reference frequency ($f_{ch}$) or a frequency ($f_{cal}$) derived therefrom, to a first input (C) of the second switch in the calibration mode;

- a signal frequency ($f_s$) derived from the output signal of the first switch, to a second input (N, M) of the second switch;

- an output signal of the second switch, to the analog circuit (23).

9. Circuit in accordance with Claim 8, wherein the first, second and third servo amplifiers are transconductance amplifiers and wherein the output signals from these transconductance amplifiers and the signals at the first and second inputs of the adder (21) and the output signal from the adder are currents.

10. Circuit in accordance with Claim 8 or 9, wherein the combined voltage is a difference voltage.

11. Circuit in accordance with one or more of the Claims 8 to 10, wherein the signal converted by a factor (k) is a signal that has been multiplied by the factor (k) in a multiplier (241).

**Revendications**

1. Un procédé pour le réglage fin automatique des fréquences pour lequel plusieurs modes de fonctionnement sont activables au sein d'un circuit intégré et pour lequel est générée au moins une grandeur de réglage ($I_{con}$) en fonction d'une fréquence de référence précise correspondante ($f_{ch}$) et pour lequel un circuit analogique (23, 33) réglable en fréquence fait l'objet d'un réglage fin avec l'aide au moins de cette grandeur de réglage dans le circuit intégré, **caractérisé en ce que** :

- la valeur de la grandeur de réglage ($I_{con}$) est influencée par une partie de circuit de référence (Cint) du circuit intégré,
- au minimum les modes de fonctionnement étalonnage (C), mesure (M) et normal (N) sont prévus,
- en mode étalonnage, on utilisera la fréquence de référence ($f_{ch}$) (en particulier une fréquence de sous-porteuse couleur) ou une fréquence ($f_{cal}$) dérivée de cette fréquence de référence base (d) pour le réglage du circuit analogique et on mémorisera ($C_{stor}$) au moins une valeur ($V_c$) influençant la grandeur de réglage ($I_{con}$),
- après le réglage effectué en mode étalonnage, on effectue en mode mesure un réglage fin d'un signal (20, 24) (en particulier un signal F1) à traiter dans le circuit analogique (23, 33) en utilisant une valeur ($V_c$) influençant la grandeur de réglage ($I_{con}$),
- en mode normal le circuit analogique fait l'objet d'un réglage fin continu par la grandeur de réglage ($I_{con}$) pendant le traitement du signal (20, 24).

2. Un procédé selon la revendication 1 pour lequel la partie de circuit de référence ($C_{int}$) représente une reproduction des paramètres significatifs modifiés par les tolérances de fabrication pour le réglage du circuit analogique (23, 33).

3. Un procédé selon la revendication 1 ou 2 pour lequel avant un premier réglage en mode normal (N) ou lors du choix d'une autre fréquence pour le signal (20, 24) à traiter dans le circuit analogique (23, 33) les modes étalonnage (C), mesure (M) et normal (M) sont activés au moins une fois l'un après l'autre.

**4.** Un procédé selon une ou plusieurs des revendications 1 à 3 pour lequel la grandeur de réglage ($I_{con}$) est générée à partir d'une grandeur de réglage de correction ($I_{cor}$) directement dérivée de la valeur ($V_c$) influençant la grandeur de réglage et d'une grandeur de commande supplémentaire ($I_{con0}$) respectant les tolérances de fabrication. Ces grandeurs de réglage ou de commande sont principalement des courants de commande et la part de la grandeur de commande supplémentaire ($I_{con0}$) dans la grandeur de réglage totale ($I_{con}$) peut être adaptée en mode étalonnage et en mode mesure en fonction des fréquences utilisées.

**5.** Un procédé selon une ou plusieurs des revendications 1 à 4 pour lequel la valeur ($V_c$) influençant la grandeur de réglage ($I_{con}$) ou la grandeur de correction ($I_{cor}$) est générée à l'aide de la différence entre un composant de tension continue de sortie du circuit analogique (23, 33) et une tension de référence définie à chaque fois ($V_{ref}$- $V_{of}$ ; $V_{ref}$).

**6.** Un procédé selon une ou plusieurs des revendications 1 à 5 pour lequel la partie de circuit de référence est un condensateur ($C_{int}$).

**7.** Un procédé selon une ou plusieurs des revendications 1 à 6 pour lequel le circuit analogique réglable en fréquence contient la partie de circuit de référence et un démodulateur FM (23, 33) avec un oscillateur interne commandé par courant ou un générateur de fréquence commandé par courant.

**8.** Circuit pour un procédé selon une ou plusieurs des revendications 1 à 7 équipé d'un circuit analogique réglable en fréquence (23, 33) avec une grandeur de réglage ($I_{con}$), doté d'un point d'alimentation pour une fréquence de référence ($f_{ch}$) de haute précision, d'un premier, deuxième et troisième commutateur, d'un premier amplificateur de réglage (T1), d'un deuxième (T2) et d'un troisième (T3), d'un premier comparateur (CL) et d'un second (CH), d'un totalisateur (21) et d'un condensateur interne ($C_{int}$), auxquels on fournit :

- une tension de sortie ($V_1$) du circuit analogique (23) aux secondes entrées du premier amplificateur de réglage (T1) et du deuxième (T2) et du premier comparateur (CL) et du second (CH) ;
- une tension de référence ($V_{réf}$) à une première entrée (251) du premier amplificateur de réglage (T1) en mode normal ;
- une tension combinée de la tension de référence ($V_{réf}$) et une tension de compensation ($V_{of}$) à une première entrée (252) du second amplificateur de réglage (T2) en mode étalonnage ;
- une tension différentielle de la tension de référence ($V_{réf}$) et une tension de seuil ($V_{th}$) à une première entrée (254) du premier comparateur (CL) et une tension cumulée de la tension de référence ($V_{réf}$) et de la tension de seuil ($V_{th}$) à une première entrée (253) du second comparateur (CH) en mode mesure ;
- un signal de sortie du premier amplificateur de réglage (T1) à une première entrée (N) du troisième commutateur en mode normal ;
- un signal de sortie du second amplificateur de réglage (T2) à une troisième entrée (C) du troisième commutateur en mode étalonnage ;
- un signal de sortie du troisième commutateur à une entrée du troisième amplificateur de réglage (T3) ;
- un signal de sortie du troisième amplificateur de réglage (T3) à une première entrée du totalisateur (21) ;
- un signal dérivé de la grandeur du condensateur interne ($C_{int}$) et modifié par un facteur (k) à une deuxième entrée du totalisateur (21) ;
- un signal de sortie du totalisateur (21) à une entrée de commande du circuit analogique (23) ;
- un signal utile à traiter dans le circuit analogique (23) à une première entrée (N) du premier commutateur en mode normal ;
- une fréquence de signal supplémentaire à une deuxième entrée (C, M) du premier commutateur en mode étalonnage et mesure ;
- la fréquence de référence de haute précision ($f_{ch}$) ou une fréquence dérivée de celle-ci à une première entrée (C) du deuxième commutateur en mode étalonnage;
- une fréquence de signal ($f_s$) dérivée du signal de sortie du premier commutateur à une deuxième entrée (N, M) du deuxième commutateur;
- un signal de sortie du deuxième commutateur du circuit analogique 23.

**9.** Un circuit selon la revendication 8 dans lequel le premier, le deuxième et le troisième amplificateurs de réglage sont des amplificateurs de transconductance et les signaux de sorties de ces amplificateurs de transconductance, ainsi que les signaux au niveau des premières et deuxièmes entrées du totalisateur (21) et le signal de sortie du totalisateur sont des courants.

**10.** Un circuit selon la revendication 8 ou 9 dans lequel la tension combinée est une tension différentielle.

11. Un circuit selon une ou plusieurs des revendications 8 à 10 dans lequel le signal déformé par un facteur (k) est un signal multiplié par le facteur (k) dans un multiplicateur (241).

FIG.1

FIG.3

FIG.2